# EUROPEAN PATENT APPLICATION

(11) **EP 4 567 440 A1**
(43) Date of publication of application: **11.06.2025**
(21) Application number: 24202987.4
(22) Date of filing: 26.09.2024
(51) Int. Cl.: G01R 31/00, G01R 31/3167, G01R 31/3187, G01R 31/317, G01R 31/28

(54) **METHOD AND MACHINE FOR FACTORY TESTING OF INTEGRATED CIRCUITS USING BUILT-IN ANALOG VOLTAGE SELF-TEST**

(30) Priority: 07.12.2023 US 202318531727
(71) Applicant: Himax Technologies Limited, Tainan City 74148 (TW)
(72) Inventor: Chang, Yaw-Guang, 74148 Tainan City (TW); Chiu, Chun-Yu, 74148 Tainan City (TW); Huang, Ren-Yuan, 74148 Tainan City (TW); Huang, Chia-Yi, 74148 Tainan City (TW)
(74) Representative: Straus, Alexander

(57) **Abstract**

A test method for performing a factory test on an automotive IC (120) includes: performing a logic test on the automotive IC (120) by sending one or more logic test input signals (Logic Test IN) to the automotive IC (120) to generate one or more logic test output signals (Logic Test OUT); while the automotive IC (120) is generating the one or more logic test output signals (Logic Test OUT), utilizing a safety detection circuit (123_1-123_M) within the automotive IC (120) to determine whether at least one analog voltage (VREG) of an analog circuit block (122_1-122_N) of the automotive IC (120) falls within a predetermined range to generate an analog test result; and determining whether the automotive IC (120) passes the factory test according to at least the logic test output signals (Logic Test OUT) and the analog test result.

## Description

### Field of the Invention

The present disclosure relates to factory testing of integrated circuits, and more particularly, to a test method, test machine and test system for facilitating factory test on integrated circuits using analog voltage self-test procedure that is built in the integrated circuits.

### Background of the Invention

Automotive integrated circuits (ICs) are customized ICs for specific applications within automotive electronic systems. The automotive ICs are engineered to meet stringent requirements of automotive applications, such as, high reliability, durability, and compliance with automotive safety standards such as ISO 26262. Typically, the automotive ICs serve various purposes within vehicle systems, such as engine control units (ECUs), sensor interfaces, infotainment systems, and advanced driver assistance systems (ADAS). Given the high demands for reliability and durability of automotive ICs, the factory testing for such ICs is usually more stringent and rigorous. In this highly specialized and technically demanding field, there is a critical need for a testing method that is both efficient and reliable.

### Summary of the Invention

The present disclosure aims to provide a testing method, a testing machine, and a testing system that utilize an embedded analog voltage self-test in automotive ICs to facilitate the factory test of said ICs. Given that the invention leverages high-accuracy safety detection circuits for conducting the analog voltage self-test, it can efficaciously supplant analog testes in conventional testing flows without compromising the reliability of the tests. Consequently, the present disclosure not only curtails the costs implicated in conventional testing flows but also mitigates the cumulative manufacturing costs of the automotive ICs.

This is achieved by a method and a testing machine for performing a factory test on an automotive IC according to the independent claim here below. The dependent claims pertain to corresponding further developments and improvements.

As will be seen more clearly from the detailed description following below, a method for performing a factory test on an automotive IC is disclosed. The method comprises: performing a logic test on the automotive IC by sending one or more logic test input signals to the automotive IC to generate one or more logic test output signals; while the automotive IC is generating the one or more logic test output signals, utilizing a safety detection circuit within the automotive IC to perform a self-test to determine whether at least one analog voltage of an analog circuit block of the automotive IC falls within a predetermined range to generate an analog test result; and determining whether the automotive IC passes the factory test according to at least the logic test output signals and the analog test result.

As will be seen more clearly from the detailed description following below, a testing machine for performing a factory test on an automotive IC is disclosed. The testing machine comprises: a logic test module and an analog test module. The logic test module is configured to perform a logic test on the automotive IC by sending one or more logic test input signals to the automotive IC and accordingly receive one or more logic test output signals that is generated by the automotive IC. The analog test module is configured to receive an analog test result that is generated by a self-test performed based on a safety detection circuit within the automotive IC while the automotive IC is generating the one or more logic test output signals. The analog test result indicates whether at least one analog voltage of an analog circuit block of the automotive IC falls within a predetermined range. The test machine is configured to determine whether the automotive IC passes the factory test according to at least the logic test output signals and the analog test result.

As will be seen more clearly from the detailed description following below, a testing system is disclosed. The test system comprises: an automotive IC and a test machine. The automotive IC comprises at least one analog circuit block; and at least on safety detection circuit configured to perform a self-test to generate an analog test result to indicate whether at least one analog voltage of the at least one analog circuit block falls within a predetermined range. The test machine is configured to perform a factory test on the automotive IC and comprises: a logic test module and an analog test module. The logic test module is configured to perform a logic test on the automotive IC by sending one or more logic test input signals to the automotive IC and accordingly receive one or more logic test output signals that is generated by the automotive IC. The analog test module is configured to receive the analog test result that is generated while the automotive IC is generating the one or more logic test output signals, wherein the test machine is configured to determine whether the automotive IC passes the factory test according to at least the logic test output signals and the analog test result.

### Brief Description of the Drawings

In the following, the disclosure is further illustrated by way of example, taking reference to the accompanying drawings.
FIG. 1 illustrates a schematic diagram of a test system according to one embodiment of the present invention.
FIG. 2 illustrates an implementation of a safety detection circuit according to one embodiment of the present invention.
FIG. 3 illustrates another implementation of a safety detection circuit according to one embodiment of the present invention.
FIG. 4 illustrates a comparative analysis between a conventional testing flow and an innovative testing flow of the present invention.
FIG. 5 illustrates a simplified flow of a testing method according to one embodiment of the present invention.

### Detailed Description

In the following description, numerous specific details are set forth in order to provide a thorough understanding of the present embodiments. It will be apparent, however, to one having ordinary skill in the art that the specific detail need not be employed to practice the present embodiments. In other instances, well-known materials or methods have not been described in detail in order to avoid obscuring the present embodiments.

Reference throughout this specification to "one embodiment" or "an embodiment" means that a particular feature, structure or characteristic described in connection with the embodiment or example is included in at least one embodiment of the present embodiments. Thus, appearances of the phrases "in one embodiment" or "in an embodiment" in various places throughout this specification are not necessarily all referring to the same embodiment. Furthermore, the particular features, structures or characteristics may be combined in any suitable combinations and/or sub-combinations in one or more embodiments.

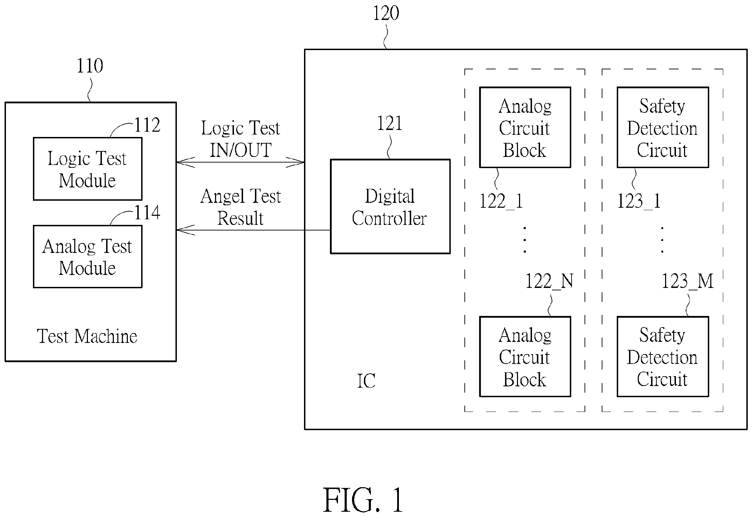

FIG. 1 illustrates a testing system according to one embodiment of the present invention. As illustrated, a testing system comprises a test machine 110 and an IC 120 under test. The test machine 110 could be a chip probe (CP) tester designed to make electrical contact with specific nodes or pads on the IC 120, enabling various tests to assess the functionality and reliability of the IC 120.

According to various embodiments, various tests can include continuity tests, functionality verification, and parametric tests to evaluate electrical characteristics of the IC 120. In one embodiment, the IC 120 could be an automotive IC designed to perform specific functions within a vehicle electronic system, such as controlling engine management, handling communication between different vehicular systems, or managing infotainment systems. The tests conducted by the test machine 110 would depend on the specific functions and applications of the IC 120, ensuring each component operates correctly and meets the required specifications and standards.

The IC 120 comprises a digital controller 121, a plurality of analog circuit blocks 122_1-122_N and a plurality of safety detection circuits 123_1-123_M. According to various embodiments, the plurality of analog circuit blocks 122_1-122_N can include components such as a voltage regulator, an oscillator, a driver circuit, an amplifier, a filter, a mixer, a comparator, a signal modulator, a phase-locked loop (PLL), a current mirror, a charge pump, a reference voltage/current generating circuit and/or an analog-to-digital or a digital-to-analog converter. Additionally, each of the analog circuit blocks 122_1-122_N is monitored by a dedicated one of the safety detection circuits 123_1-123_M, thereby to ensure analog voltages of (i.e., within of outputted by) each of the analog circuit blocks 122_1-122_N remains within a specified safety range. As such, accuracy and precision of analog voltages of the analog circuit blocks 122_1-122_N can be ensured, thereby guaranteeing that IC 120 can operate normally even under various harsh environments.

Generally, the safety detection circuits 123_1-123_M are designed to configured to meet different requirements of the safety standard, such as automotive safety integrity level (ASIL)-B, ASIL-C and ASIL-D. The safety detection circuits 123_1-123_M are typically utilized to perform an analog voltage self-test during a boot-up process of the IC 120 and during a normal operation of the IC 120. During the boot-up process of the IC 120, the analog voltage self-test will be initiated by the digital controller 121. If any of the analog voltages of the analog circuit blocks 122_1-122_N that are monitored by the safety detection circuits 123_1-123_M falls outside a predetermined safety range, the digital controller 110 would report the error to a host (not shown) based on detections of the safety detection circuits 123_1-123_M. During specified intervals (e.g., a "porch" period in display applications) within the normal operation of the IC 120, the analog voltage self-test will be also initiated also by the digital controller 121. If any of the analog voltages of the analog circuit blocks 122_1-122_N that are monitored by the safety detection circuits 123_1-123_M voltage falls outside the safety range, the safety detection circuits 123_1-123_M will detect it and the digital controller 110 accordingly reports the error to the host.

In view of this, if the safety detection circuit 123_1-123_M can achieve high accuracy, this means that its detection capability would cover analog test that is commonly necessitated in a testing flow. Hence, it is possible to utilize the analog voltage self-test functionality provided by the safety detection circuit 123_1-123_M to facilitate the analog test in the testing flow, which is conventionally done by measurement with external probes. In embodiments of the present invention, an analog test module 114 of the test machine 110 does not need to measure analog voltages of the analog circuit blocks 122_1-122_N. Instead, the analog test module 114 of the test machine 110 only needs to receive an analog test result generated by the digital controller 110. The analog test will be achieved by the analog voltage self-test inside the IC 120.

During a testing flow of the present invention, the test machine 110 may send a variety of test input signals (e.g., test patterns) to the IC 120. In response to the test input signals sent by the test machine 110, various components within the IC 120 generates test output signals and the digital controller 121 accordingly transmits the test output signals or feedback a result based on the test output signals to the test machine 110.

In one embodiment, a logic test module 112 of the test machine 110 would initiate a logic test by sending logic test input signals to the IC 120. Relevant components within the IC 120 accordingly generates logic test output signals. While the logic test is being performed, the digital controller 121 would concurrently initiate the analog voltage self-test. Specifically, the digital controller 121 would instruct the safety detection circuit 123_1-123_M to detect whether analog voltages of the analog circuit blocks 122_1-122_N falls within the predetermined safety range, while other circuit blocks (not shown) of the IC 120 are under logic test, i.e., generating logic test output signals in response to logic test input signals.

Once it is found that any of the analog voltages of the analog circuit blocks 122_1-122_N falls outside the predetermined safety range, the digital controller 121 would send the analog test result indicative of analog test failed to the analog test module 114 of the test machine 110. Otherwise, the digital controller 121 would send the analog test result indicative of analog test passed. According to the analog test result received by the analog test module 114 and the logic test output signals received by the logic test module 112, the test machine 100 determines whether the IC 120 passes the test.

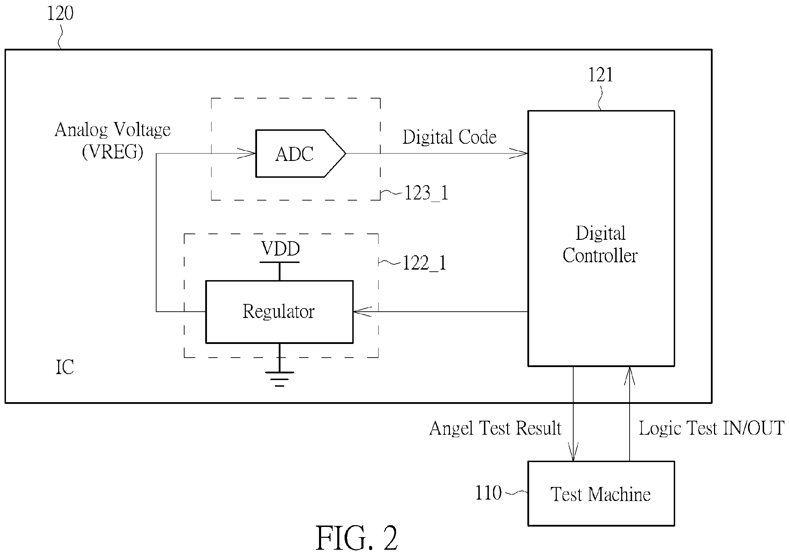

FIG. 2 illustrates a possible implementation of a safety detection circuit according to one embodiment of the present invention. As illustrated, a safety detection circuit 123_1 could comprise an analog-to-digital converter (ADC). In this embodiment, it is assumed that the analog circuit block 122_1 comprises a regulator that is used to convert a supply voltage VDD to a regulated voltage VREG. During the logic test, the analog voltage self-test is initiated, and the ADC in the safety detection circuit 123_1 is configured to convert the regulated voltage VREG to a digital code. The digital controller 121 receives the digital code and determines whether the digital code fall within a predetermined range. For example, if the regulated voltage VREG is expected to be 5V with a permissible error of 10mV, once the digital code reflective of the regulated voltage VREG falls within a range from 4.99V to 5.01V, the digital controller 121 will deem the analog circuit block 122_1 passes the analog test. Otherwise, the digital controller 121 will deem the analog circuit block 122_1 fails to pass the analog test.

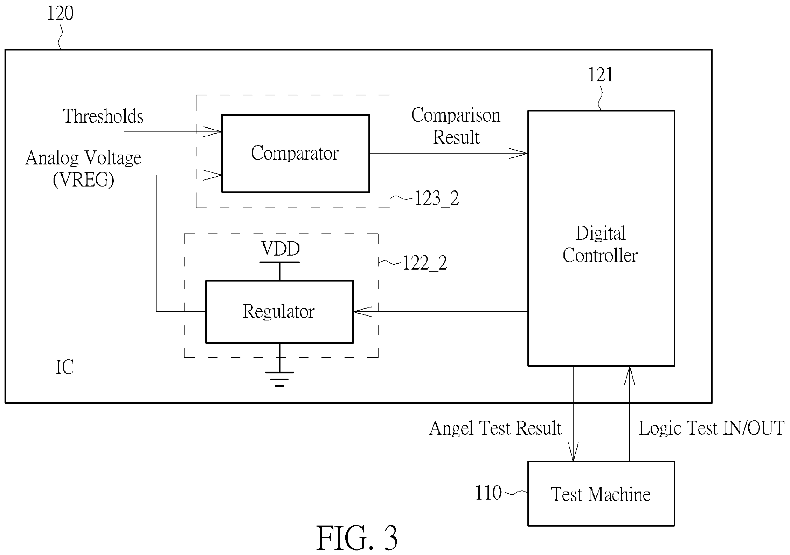

FIG. 3 illustrates another possible implementation of a safety detection circuit according to one embodiment of the present invention. As illustrated, a safety detection circuit 123_2 could comprise a comparator. In this embodiment, it is also assumed that the analog circuit block 122_2 comprises a regulator that is used to convert a supply voltage VDD to a regulated voltage VREG. During the logic test, the analog voltage self-test is initiated and the comparator in the safety detection circuit 123_2 is configured to compare the regulated voltage VREG with one or more predetermined thresholds. The digital controller 121 receives comparison results and determines whether the regulated voltage VREG fall within a predetermined range. For example, if the regulated voltage VREG is expected 5V with a permissible error of 10mV, once the comparison result reflective of the regulated voltage VREG falls within a range from 4.99V to 5.01V, the digital controller 121 will deem the analog circuit block 122_2 passes the analog test. Otherwise, the digital controller 121 will deem the analog circuit block 122_2 fails to pass the analog test.

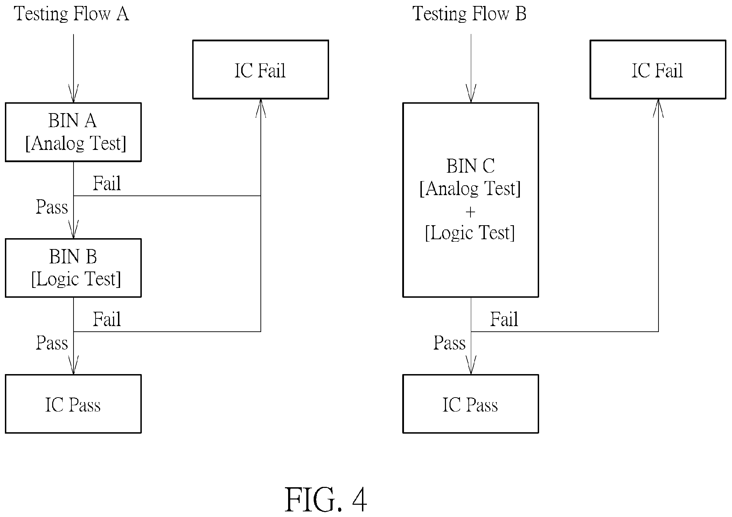

FIG. 4 illustrates a comparative analysis between a conventional testing flow A, and an innovative testing flow B of the present invention. In the conventional testing flow, A, there are two distinct testing stages: BIN A and BIN B, which are utilized to execute the analog test and the logic test respectively. Contrastingly, the testing flow B of the present invention, streamlines the testing flow by integrating an analog voltage self-test within the logic test, allowing both the analog and logic tests to be conducted simultaneously in a single stage BIN C. This approach significantly reduces the time and resources traditionally required to perform the analog and logic tests in separate testing stages, thereby contributing to a substantial reduction in the manufacturing costs of the ICs.

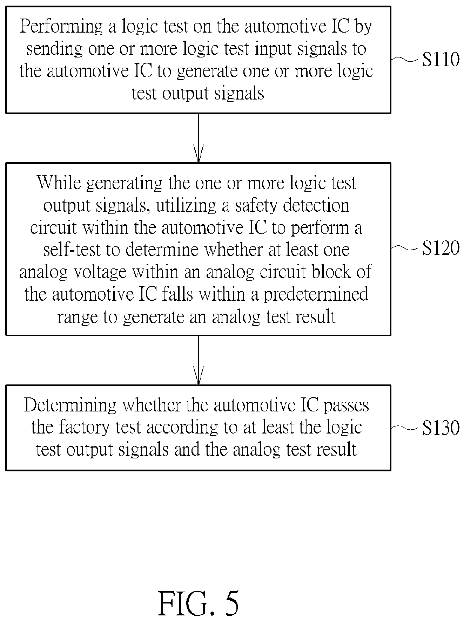

FIG. 5 illustrates a testing method according to one embodiment of the present invention. As shown in the figure, the method of the present invention includes the following simplified flow as follow.

| | |
|---|---|
| Step S110: | performing a logic test on the automotive IC by sending one or more logic test input signals to the automotive IC to generate one or more logic test output signals; |
| Step S120: | while the automotive IC is generating the one or more logic test output signals, utilizing a safety detection circuit within the automotive IC to perform a self-test to determine whether at least one analog voltage of an analog circuit block of the automotive IC falls within a predetermined range to generate an analog test result; and |
| Step S130: | determining whether the automotive IC passes the factory test according to at least the logic test output signals and the analog test result. |

Since principles and specific details of the foregoing steps have been explained in detail through the above embodiments, further descriptions will not be repeated here. It should be noted that the above flow may be possible, by adding other extra steps or making appropriate modifications and adjustments, to better improve flexibility and further improve efficiency of the IC testing.

In summary, the test method of the present invention utilizes high-accuracy built-in safety detection circuits that can handle analog tests for a factory testing flow, which saves time and reduce overall costs without compromising quality. As such, the test method of the present invention is not only to ensure that each IC meets the stringent standards of the automotive industry but also to maintain efficiency throughout the manufacturing process. This is vital to keeping the manufacturing costs within acceptable limits and ensuring a swift time-to-market for the products.

## Claims

1. A test method for performing a factory test on an automotive integrated circuit (IC) (120), **characterized by** comprising:
performing a logic test on the automotive IC (120) by sending one or more logic test input signals (Logic Test IN) to the automotive IC (120) to generate one or more logic test output signals (Logic Test OUT);
while the automotive IC (120) is generating the one or more logic test output signals (Logic Test OUT), utilizing a safety detection circuit (123_1-123_M) within the automotive IC (120) to perform a self-test to determine whether at least one analog voltage (VREG) of an analog circuit block (122_1-122_N) of the automotive IC (120) falls within a predetermined range to generate an analog test result; and
determining whether the automotive IC (120) passes the factory test according to at least the logic test output signals (Logic Test OUT) and the analog test result.

2. The test method of claim 1, **characterized in that** the safety detection circuit (123_1-123_M) of the automotive IC (120) comprises an analog-to-digital converter (ADC) (123_1), and the ADC (123_1) is configured to convert the at least one analog voltage (VREG) into a digital code, and the step of determining whether the at least one analog voltage (VREG) falls within the predetermined range comprises:
utilizing a controller (121) within the automotive IC (120) to determine whether the digital code falls within the predetermined range to generate the analog test result.

3. The test method of claim 1, **characterized in that** the safety detection circuit (123_1-123_M) of the automotive IC (120) comprises a comparator (123_2), and the comparator (123_2) is configured compare the at least one analog voltage (VREG) of one or more predetermined voltages, and the step of determining whether the at least one analog voltage (VREG) falls within the predetermined range comprises:
utilizing the comparator (123_2) to determine whether the at least one analog voltage (VREG) falls within the predetermined range to generate comparison results; and
utilizing the utilizing a controller (121) within the automotive IC (120) to generate the analog test result based on the comparison result.

4. The test method of claim 1, **characterized in that** the automotive IC (120) comprises one or more analog circuit blocks (122_1-122_N) and the one or more analog circuit blocks (122_1-122_N) comprises at least one of a voltage regulator, an oscillator, a driver circuit, an amplifier, a filter, a mixer, a comparator, a signal modulator, a phase-locked loop (PLL), a current mirror, a charge pump, a reference voltage/current generating circuit and/or an analog-to-digital or a digital-to-analog converter.

5. The test method of claim 1, **characterized in that** the safety detection circuit (123_1-123_M) is further operated to generate the analog test result during a boot-up process or a normal operation of the automotive IC (120).

6. A testing machine (110) for performing a factory test on an automotive integrated circuit (IC) (120), **characterized by** comprising:
a logic test module (112), configured to perform a logic test on the automotive IC (120) by sending one or more logic test input signals (Logic Test IN) to the automotive IC (120) and accordingly receive one or more logic test output signals (Logic Test OUT) that is generated by the automotive IC (120); and
an analog test module (114), configured to receive an analog test result that is generated by a self-test performed based on a safety detection circuit (123_1-123_M) within the automotive IC (120) while the automotive IC (120) is generating the one or more logic test output signals (Logic Test OUT), wherein the analog test result indicates whether at least one analog voltage (VREG) of an analog circuit block (122_1-122_N) of the automotive IC (120) falls within a predetermined range;
wherein the test machine (110) is configured to determine whether the automotive IC (120) passes the factory test according to at least the logic test output signals (Logic Test OUT) and the analog test result.

7. The testing machine (110) of claim 6, **characterized in that** the safety detection circuit (123_1-123_M) of the automotive IC (120) comprises an analog-to-digital converter (ADC) (123_1), the ADC (123_1) is configured to convert the at least one analog voltage (VREG) into a digital code, and a controller (121) within the automotive IC (120) is configured to generate the analog test result by determining whether the digital code falls within the predetermined range.

8. The testing machine (110) of claim 6 **characterized in that** the safety detection circuit (123_1-123_M) of the automotive IC (120) comprises a comparator (123_2), the comparator (123_2) is configured to determine whether the at least one analog voltage (VREG) falls within the predetermined range to generate comparison results, and a controller (121) within the automotive IC (120) is configured to generate the analog test result based on the comparison result.

9. The testing machine (110) of claim 6, **characterized in that** the automotive IC (120) comprises one or more analog circuit blocks (122_1-122_N) and the one or more analog circuit blocks (122_1-122_N) comprises at least one of a voltage regulator, an oscillator, a driver circuit, an amplifier, a filter, a mixer, a comparator, a signal modulator, a phase-locked loop (PLL), a current mirror, a charge pump, and/or an analog-to-digital or a digital-to-analog converter.

10. The testing machine (110) of claim 6, **characterized in that** the safety detection circuit (123_1-123_M) is further operated to generate the analog test result during a boot-up process or a normal operation of the automotive IC (120).

11. A testing system, **characterized by** comprising:
an automotive integrated circuit (IC) (120), comprising:
at least one analog circuit block (122_1-122_N); and
at least on safety detection circuit (123_1-123_M), configured to perform a self-test to generate an analog test result to indicate whether at least one analog voltage (VREG) of the at least one analog circuit block (122_1-122_N) within a predetermined range;
a test machine (110), configured to perform a factory test on the automotive IC (120), comprising:
a logic test module (112), configured to perform a logic test on the automotive IC (120) by sending one or more logic test input signals (Logic Test IN) to the automotive IC (120) and accordingly receive one or more logic test output signals (Logic Test OUT) that is generated by the automotive IC (120); and
an analog test module (114), configured to receive the analog test result that is generated while the automotive IC (120) is generating the one or more logic test output signals (Logic Test OUT);
wherein the test machine (110) is configured to determine whether the automotive IC (120) passes the factory test according to at least the logic test output signals (Logic Test OUT) and the analog test result.

12. The testing system of claim 11, **characterized in that** the safety detection circuit (123_1-123_M) of the automotive IC (120) comprises an analog-to-digital converter (ADC) (123_1), the ADC (123_1) is configured to convert the at least one analog voltage (VREG) into a digital code, and a controller (121) within the automotive IC (120) is configured to generate the analog test result by determining whether the digital code falls within the predetermined range.

13. The testing system of claim 11, **characterized in that** the safety detection circuit (123_1-123_M) of the automotive IC (120) comprises a comparator (123_2), the comparator (123_2) is configured to determine whether the at least one analog voltage (VREG) falls within the predetermined range to generate comparison results, and a controller (121) within the automotive IC (120) is configured to generate the analog test result based on the comparison result.

14. The testing system of claim 11, **characterized in that** the automotive IC (120) comprises one or more analog circuit blocks (122_1-122_N) and the one or more analog circuit blocks (122_1-122_N) comprises at least one of a voltage regulator, an oscillator, a driver circuit, an amplifier, a filter, a mixer, a comparator, a signal modulator, a phase-locked loop (PLL), a current mirror, a charge pump, a reference voltage/current generating circuit and/or an analog-to-digital or a digital-to-analog converter.

15. The testing system of claim 11, **characterized in that** the safety detection circuit (123_1-123_M) is further operated to generate the analog test result during a boot-up process or a normal operation of the automotive IC (120).
